Europäisches Patentamt

European Patent Office

Office européen des brevets

(19)

(11) **EP 1 455 454 A2**

(12) **EUROPÄISCHE PATENTANMELDUNG**

(43) Veröffentlichungstag:
**08.09.2004 Patentblatt 2004/37**

(51) Int Cl.[7]: **H03K 17/95**, G01D 5/20

(21) Anmeldenummer: **04405127.4**

(22) Anmeldetag: **03.03.2004**

| (84) | Benannte Vertragsstaaten:<br>**AT BE BG CH CY CZ DE DK EE ES FI FR GB GR HU IE IT LI LU MC NL PL PT RO SE SI SK TR**<br>Benannte Erstreckungsstaaten:<br>**AL HR LT LV MK** | • **Onda, Nicolino**<br>  **7310 Bad Ragaz (CH)**<br>• **Kutzelmann, Peter**<br>  **6317 Oberwil b. Zug (CH)**<br>• **Heldstab, Hans**<br>  **7212 Seewis-Dorf (CH)** |
|---|---|---|
| (30) | Priorität: **07.03.2003 CH 3512003** | |
| (71) | Anmelder: **ELESTA relays GmbH**<br>**7310 Bad Ragaz (CH)** | (74) Vertreter: **Walder, Martin Bernhard et al**<br>**Riederer Hasler & Partner**<br>**Patentanwälte AG**<br>**Elestastrasse 8**<br>**7310 Bad Ragaz (CH)** |
| (72) | Erfinder:<br>• **Greber, Alexander**<br>  **6205 Eich (CH)** | |

(54) **Induktive Überwachungsvorrichtung und Verfahren zur Überwachung des Abstands zwischen einer ersten und einer zweiten Spule**

(57) Bei der erfindungsgemässen, induktiven Überwachungsvorrichtung (11) kann mit einer ersten Luftspule (16) in einem Senderteil (13) in Messrichtung ein hochfrequentes elektromagnetisches Feld aufgebaut werden (etwa 3 MHz), das eine Wechselspannung in einer zweiten Spule (19) eines Betätigerteil (15) induziert.

Im Betätigerteil (15) wird die vom Abstand abhängige Energie aus der empfangenden zweiten Spule (19) gleichgerichtet und z.B. in einem Kondensator gespeichert. Die gespeicherte Energie kann z.B. teilweise zurück zum Sendeteil (13) gesendet oder mit einer Last (21) auch einfach verbraucht werden (in Fig.3 bis Fig.7 ist die Last als ohmschen Verbraucher dargestellt).

Wenn mit dem elektromagnetischen Wechselfeld ein magnetisch gekoppelter elektronischer Verbraucher, z.B. ein Sender oder eine ohmsche Last, angeregt wird, so bewirkt dies eine Veränderung des Energieverbrauchs des Senderteil (13). Diese Veränderung der Senderleistung (dP/dt) wird erkannt und mit einem Schwellwert verglichen. Abhängig vom Ergebnis des Vergleiches wird wenigstens ein Ausgang der Überwachungsvorrichtung (11) aktiv oder passiv geschaltet.

Fig. 1

EP 1 455 454 A2

**Beschreibung**

Die Erfindung betrifft eine Überwachungsvorrichtung mit einer mit Wechselspannung betreibbaren ersten Spule in einem Senderteil und einer mit einem Verbraucher verbundenen zweiten Spule in einem gegenüber dem Senderteil beweglichen Betätigerteil. Bei solchen Überwachungsvorrichtung sind die erste Spule und die zweite Spule aufeinander auszurichten, um im Betrieb induktiv zusammenwirken zu können. Somit kann der Abstand zwischen der ersten Spule und der zweiten Spule überwacht werden. Eine solche Überwachungsvorrichtung ist daher insbesondere ein induktiver Näherungsschalter zur Überwachung der Relativstellung von zwei relativ zueinander beweglichen Teilen, z.B. zur Überwachung der Position eines Verschlusses eines Zugangs zu einem gefährlichen Bereich. Die Erfindung betrifft auch ein Verfahren zur Überwachung des Abstands zwischen einer ersten Spule eines Senderteils und einer zweiten Spule eines Betätigerteils, bei welchem Verfahren mit der ersten Spule ein Wechsel-Magnetfeld aufgebaut wird und mit dem Wechsel-Magnetfeld in der an einen Verbraucher angeschlossenen zweiten Spule eine Wechselspannung induziert wird.

Aus der EP 0 968 567 A ist ein Sicherheitsschalter zur Überwachung von beweglichen Schutzeinrichtungen bekannt. Der Sicherheitsschalter besitzt ein Schaltglied, das wenigstens einen Lesekopf aufweist. Er besitzt ferner ein relativ zum Lesekopf bewegliches Betätigerelement, das mit dem Lesekopf über eine Induktivität zusammenwirkt. Das Betätigerelement enthält in einem Speicher eine elektronische Codierung. Diese Codierung identifiziert das Betätigungselement eindeutig. Dem Lesekopf ist eine Auswerteinrichtung nachgeschaltet. Die Auswerteinrichtung enthält eine elektronische Codierung, welche in wenigstens einem weiteren Speicher vorliegt. Diese Codierung identifiziert den Lesekopf oder das Schaltglied eindeutig. Der Lesekopf nimmt im Betrieb Signale auf, die in der Auswerteinrichtung ausgewertet werden.

Im Betätigerelement ist eine Spule vorgesehen. Diese Spule bildet zusammen mit einem Kondensator einen Schwingkreis, zu dem ein IC-Baustein parallel liegt. Die Spule des Lesekopfes und die Spule des Betätigerelements bilden zusammen einen Transformator mit einem Kopplungsfaktor von 0,01 bis 0,1. Die Spule des Lesekopfes strahlt ein magnetisches Wechselfeld aus, das in der Spule des Betätigerelements eine Spannung induziert und im Schwingkreis eine Schwingung anregt. Der IC-Baustein weist einen Gleichrichter auf, so dass er dem Schwingkreis Energie entnehmen kann. Im IC-Baustein ist ein 32 Bit langer Code gespeichert. Mit diesem Code moduliert der IC-Baustein die Amplitude des Schwingkreises mit einer Rate von 1 Bit pro msec. Durch Rückkoppelung auf die Spule im Lesekopf wird auch der Schwingkreis des Lesekopfes moduliert. Dieses modulierte Signal wird über einen Empfangsverstärker an Mikroprozessoren zugeführt. Die Mikroprozessoren vergleichen den empfangenen Code mit einem gespeicherten Code und geben bei Übereinstimmung der Code einem Relais ein Signal zum Schliessen eines Schalters. Die für die Auswertung vorgesehenen Teile der Auswerteinrichtung sind doppelt vorhanden.

Dieser und weitere Sicherheitsschalter arbeiten auf dem Prinzip der Verstimmung eines Induktivität-Kapazität-Schwingkreises (LC-Schwingkreis). Der LC-Schwingkreis kann dabei codiert oder moduliert werden.

Nachteilig an solchen Sicherheitsschaltern ist unter anderem, dass die Frequenzen solcher Sicherheitsschalter im KHz-Bereich liegen müssen, damit eine Abstimmung der Frequenzen von Sender und Empfänger wirtschaftlich wird. Die Produktionstoleranzen bei der Kapazität von Kondensatoren wie auch bei der Induktivität von Spulen liegt um 10% oder höher. Daher weisen die Frequenzen von LC-Schwingkreisen identischer Bauweise produktionsbedingt relativ grosse Unterschiede auf und sind zudem temperaturabhängig. Diese Toleranzen und die mit zunehmender Frequenzhöhe zunehmende Intensität von Streukapazitäten und Streuinduktivitäten erlaubt nicht, Schwingkreise mit definierten Frequenzen im MHZ-Bereich wirtschaftlich herzustellen.

Für Frequenzen im KHz-Bereich sind grosse Induktivitäten und Kondensatoren erforderlich. Zum Erreichen von grossen Induktivitäten sind Spulen mit hochpermeablen Kernen notwendig. Ein maximaler Abstand zwischen zwei zusammenwirkenden Spulen ist in der Folge jedoch stark von der Grösse der Kerne abhängig. Da diese Kerne bei mehreren 100 kHz aber bereits starke Dämpfungen aufweisen, werden die Frequenzen herkömmlicher LC-Schwingkreise für Sicherheitsschalter entsprechend tief gewählt.

Aus der DE 102 22 186 C, deren Priorität für die parallele EP 1 363 400 A beansprucht ist, ist nach dem Prioritätstag dieser Anmeldung ein Sicherheitsschalter bekannt geworden. Dieser weist eine Erkennungseinrichtung für einen Betätiger auf, welche an eine Schalteinrichtung gekoppelt ist. Der Sicherheitsschalter umfasst ein Sendeelement zum Emittieren elektromagnetischer Signale und eine Auswerteschaltung. Die Auswerteschaltung erzeugt in Abhängigkeit von an einem Empfangselement induzierten elektrischen Signalen ein Schaltsignal zum Aktivieren der Schalteinrichtung. Die Auswerteeinrichtung umfasst einen Integrator und eine Vergleichseinrichtung. Der Integrator ist an einen Zeitgeber gekoppelt, um während einer dem Emittieren folgenden Zeitspanne eine im Empfangselement induzierte elektrische Energiemenge zu erfassen. Die Vergleichseinrichtung stellt das Schaltsignal bereit, wenn diese erfasste Energiemenge einen vorbestimmten Schwellenwert über- oder unterschreitet.

Bei diesem Sicherheitsschalter müssen daher die Sendezyklen mit Empfangszyklen abwechseln. Gemessen wird lediglich die zurückgekehrte Energie, welche in einem Empfangszyklus den Schwingkreis des Empfangselements anregt. Daher muss die Sendeleistung des Schwingkreises des Betätigers genügend hoch und genügend auf den Schwingkreis des Empfangselements abgestimmt sein, um den im Empfangselement vorliegenden Schwingkreis möglichst effektiv anzuregen.

Es ist deshalb Aufgabe der Erfindung, eine Überwachungsvorrichtung der eingangs erwähnten Gattung zu schaffen, welche unempfindlich ist gegenüber produktionsbedingten Kapazitätstoleranzen bei den Kondensatoren und produktionsbedingten Induktivitätstoleranzen bei den Spulen.

Weiter soll die Überwachungsvorrichtung mit möglichst kleinen Abmessungen eine möglichst grosse Reichweite besitzen. Sie soll daher vorteilhaft mit Luftspulen und Frequenzen im MHz-Bereich betrieben werden können. Die Überwachung soll während dem Senden eines Signals erfolgen können.

Erfindungsgemäss wird dies bei einer Überwachungsvorrichtung gemäss dem Oberbegriff des Anspruchs 1 durch die kennzeichnenden Merkmale des Anspruchs 1 erreicht. Das vorsehen einer Einrichtung zur Messung des Energieverbrauchs des Sendeteils ermöglicht eine frequenztolerante Abstandsmessung zwischen den beiden Spulen. Dadurch dass die Messung des Energieverbrauchs und gegebenenfalls der Änderung des Energieverbrauchs senderseitig geschieht und das Betätigerteil über Induktion mit Energie versorgt wird, kann das Betätigerteil unabhängig von Leitungen sehr frei angeordnet werden.

Der Energieverbrauch und die Energieverbrauchsänderung des Senderteils wird vorteilhaft durch das Messen des Spannungsabfalles eines Widerstands bestimmt. Beides kann auch anhand der Hallspannung /Hallspannungsänderung eines Hallelements ermittelt werden. Der Widerstand oder das Hallelement muss dabei in Reihe zwischen der ersten Spule und der DC-Versorgungsquelle geschaltet sein. Vorteilhaft ist der Widerstand, bzw. das Hallelement zwischen einem der ersten Spule zugeordneten Oszillator und der DC-Versorgungsquelle angeordnet.

Die Charakteristika der DC-Versorgungsquelle müssen für die Erstellung einer Energiebilanz bekannt sein. Ist die Versorgungsquelle nicht konstant, so muss die Energiebilanz rechnerisch ermittelt werden, wobei die Schwankungen der Versorgungsquelle in der Rechnung berücksichtigt werden müssen. Vorteilhaft ist die Versorgungsquelle deshalb konstant. Dies ermöglicht eine einfache Messung des Stromverbrauchs. Eine konstante DC-Versorgungsquelle ist z.B. eine konstante Gleichspannungs-Quelle, eine konstante Gleichstromquelle oder eine konstante Leistungsquelle.

Bei einem Verfahren gemäss dem Oberbegriff des Patentanspruchs 17 wird die Lösung der Aufgabe entsprechend durch die kennzeichnenden Merkmale des Anspruchs 17 erreicht. Dank einer Überwachung des gegenseitigen Abstands der Spulen mittels einer Energiebilanz des Senderteils ist diese Überwachung praktisch unabhängig von der Frequenz von Sender und Empfänger. Die Frequenz des Empfängers kann jedoch zusätzliche Informationen über den Abstand zwischen Sender und Empfänger enthalten.

Die Energiebilanz wird vorteilhaft durch eine Stromverbrauchsmessung ermittelt. Eine Stromverbrauchsmessung ist praktisch unabhängig von der Frequenz des Wechselmagnetfeldes bzw. der Wechselspannung möglich. Deshalb ist die Unempfindlichkeit der Stromverbrauchsmessung gegenüber Toleranzen in den frequenzbestimmenden Bauelementen bzw. der Frequenz selbst sehr gross.

Die folgende Herleitung dient als theoretische Grundlage für eine Stromverbrauchsmessung:

$$1) \qquad Pzu = Pab,$$

d.h. bei einem geschlossenen System (einer Schaltung) muss die dem System zugeführte Energie (Leistung) gleich gross sein wie die dem System entzogenen Energie.

$$2) \qquad Pab = Pzu - Pv\text{-Schaltung},$$

d.h.: Die aus dem System oder der Schaltung abgeführte Energie entspricht der zugeführten Energie nach Abzug der im System verbrauchten Energie (der im System entstandenen Wärmeenergie).

Ferner gelten die Gleichungen 3a), 3b) und 3c), wobei P für Energie, U für Spannung, I für Strom und R für Widerstand steht.

$$3a) \qquad P = U * I$$

$$3b) \qquad P = I^{2} * R$$

$$3c) \qquad P = U^{2} / R$$

Falls nun die Betriebsspannung U einer (Teil-) Schaltung konstant ist, folgt aus der Gleichung 3a): P= k*(I) wobei k eine Konstante ist. Der Energieverbrauch ist somit nur abhängig vom Strom.

Falls nun der Widerstand R einer (Teil-)Schaltung konstant ist, folgt aus 3b): P= $I^2$ * k (der Energieverbrauch ist allein vom aktuellen Strom abhängig), und aus 3c): P= $U^2$ / k (der Energieverbrauch ist allein vom aktuellen Spannungsabfall an R abhängig). Wird also ein idealer Widerstand R an einer idealen Wechselstromquelle mit idealen Leitungen angeschlossen, so sind sämtliche reellen Informationen bezüglich der Energiequelle am Widerstand ersichtlich. Ersichtlich sind insbesondere:

- Die Kurvenform (Sinus, Rechteck, Dreieck etc.)
- Die Frequenz
- Der Gleich- (DC-) Strom
- Der Wechsel- (AC-) Strom

Für die imaginären Informationen, z.B. für die Blind- und Scheinleistungsberechnung, muss zusätzlich die Phasenlage berücksichtigt werden.

Wird nun eine ideale Spule mit einer idealen AC-Leistungsquelle bei idealen Bedingungen betrieben, so ist die Summe des daraus resultierenden vektoriellen Magnetfeldes wiederum eine komplexe Funktion multipliziert mit der Quellenleistung. Das heisst, falls in naher Umgebung der Spule Wirkleistung entzogen oder zusätzliche Leistung aufgebracht wird, kann dies auch in der DC-Versorgungsquelle gesehen werden. Je nach Art der DC-Versorgungsquelle (konstanter Strom, konstante Spannung, konstante Leistung) ist der Entzug von Leistung entweder im Strom, oder in der Spannung, oder aus beiden in Kombination zu ersehen.

Wird nun die Spule über einen Widerstand an einer fest eingestellten Versorgungsquelle angeschlossen, so kann alleine über den Spannungsabfall am Widerstand eine Berechnung der aktuellen Wirkleistung gemacht werden (vergleiche Gleichung 3c). Der aktuelle Spannungsabfall ($U_{Mess}$) entspricht dabei der Summe aller Ströme der Schaltung selbst und den zusätzlich resultierenden Strömen als Folge einer zusätzlichen Energieänderung, welche auf irgendeine Art in die Schaltung eingebracht wird.

Indem aus der Spule magnetische Feldenergie entzogen bzw. über ein Magnetfeld zusätzliche Energie zugeführt wird, geschieht eine Energieänderung (dP/dt). Dieser Effekt wird ausgenutzt um den Abstand oder die Lage zweier oder mehrerer Spulen zueinander zu bestimmen. Je grösser der Abstand der beiden Spulen zueinander ist, umso schlechter ist die gegenseitige Koppelung. Somit ergibt sich umgekehrt aus der Messung des Kopplungsfaktors eine Aussage über den Abstand der beiden Spulen zueinander. Wird nun eine konstante Last an der Empfangsspule angeschlossen, kann über den sendeseitigen Energieverbrauch die Entfernung der zweiten Spule unabhängig von der Frequenz der Energieübertragung ermittelt werden. Dies ist möglich dank der als Funktion des Abstandes variablen Koppelung der Spulen.

Um diese Gesetzmässigkeit für eine Überwachungsvorrichtung zu nutzen, werden lediglich zwei Spulen, ein Widerstand, eine AC-Quelle und eine Last benötigt. Eine der beiden Spulen wirkt als Energiesender und ist mit einem Widerstand an der AC-Quelle angeschlossen. Die andere Spule zusammen mit beispielsweise einer ohmschen Last wirkt als Energieverbraucher.

Für eine den technischen Normen entsprechende Sicherheitsschaltung muss ausgeschlossen werden können, dass die gemessene Energieänderung in der ersten Spule eine andere Ursache hat als der Einfluss der zweiten Spule. Es ist jedoch nicht mit letzer Sicherheit auszuschliessen, dass auch andere Gegenstände und Materialien Eigenschaften aufweisen könnten, die den Eigenschaften des oben beschriebenen, sehr einfachen Verbrauchers, ähnlich sind. Deshalb ist eine Schaltung für eine sichere Applikation vorteilhaft mit einem Zusatz erweitert. Eine solche Zusatzschaltung kann entweder im Empfänger und/oder im Sender verwirklicht werden.

Senderseitig kann für eine sicherere Erkennung der Einsatz einer variablen Sendestufe helfen, genauere Informationen aus dem sich in der Nähe befindlichem Objekt zu erhalten. Eine Variation der Sendestufe ist möglich durch Variieren der Sendeleistung, der Frequenz und/oder der Phasenlage. Eine Variation der Sendestufe ist zusätzlich oder alternativ auch möglich durch eine Modulation der Amplitude, der Frequenz und/oder der Phase.

Empfängerseitig können für eine sicherere Erkennung die Lastverhältnisse variiert werden. Ein Zurücksenden von Energie vom Betätigerelement auf das Sender/Empfängerelement ist dazu nicht erforderlich. Es kann jedoch auch Energie mit der zweiten Spule an die erste Spule zurück übertragen werden. Beides kann auch gleichzeitig erfolgen.

Mit zusätzlichen Schaltungsteilen auf der Senderseite kann in der Folge die durch das Betätigerteil verursachte Energieveränderung eindeutig erkannt und von anders verursachten Energieveränderungen unterschieden werden.

Auf diese Weise kann auch praktisch ausgeschlossen werden, dass Fremdfelder, verursacht durch andere sendefähige Schaltungen, senderseitig eine Energieveränderung verursachen, welche von der durch das Betätigerteil verursachten Energieveränderung nicht unterscheidbar ist.

Um die Wahrscheinlichkeit einer Fehldetektion aufgrund eines solchen Fremdfeldes zu senken, können vorteilhaft Schaltungsteile im Sendeteil zyklisch ein- und ausgeschaltet werden. Damit wird abwechselnd ein Fehlerbetrieb und ein Nichtfehlerbetrieb simuliert. Diese zyklischen Abwechslungen von Fehlerbetrieb und Nichtfehlerbetrieb werden überwacht und lediglich Abweichungen vom vorgegebenen Zyklus als Fehler angezeigt. Wird nun während dem absichtlich geschalteten Fehlerbetrieb kein Fehler festgestellt, kann auf ein Fremdfeld geschlossen werden, welches im Senderteil eine dem Nicht-Fehlerbetrieb entsprechende Energieveränderung hervorruft. Es wird nun durch eine logische Schaltung das Vorhandensein des Fremdfelds angezeigt. Mit der logischen Schaltung wird somit sowohl bei Vorhandensein eines Signals während dem Fehlerbetrieb als auch bei Abwesenheit des Signals bei Nichtfehlerbetrieb das Ausgangssignal der Überwachungsvorrichtung derart geschaltet, dass es einem Fehler entspricht. Es wird demnach in beiden Fällen beispielsweise eine geschützte Maschine abschaltet oder ein Alarm ausgelöst.

Für eine Erhöhung der Sicherheit kann zusätzlich zur Energiemessung auch eine Messung der Phasenlage zwischen Spannung und Strom vorgenommen werden.

Die Erkennung des Betätigerteils anhand seines Einflusses auf den Senderteil wird somit bei sicheren Applikationen vorteilhaft aus der Energiemessung in Verbindung mit Signalverarbeitung erreicht. Die Signalverarbeitung ist mittels Hardware-Lösungen und/ oder Software-Lösungen möglich. Hardware-Lösungen sind, ausser bei speziellen Anwendungen, den Softwarelösungen vorzuziehen, da der Aufwand für Programmierung und Zulassung von Software-Lösungen relativ hoch ist.

Um jedoch eine eindeutige Identifikation eines einzelnen Betätigerteils unter typgleichen Betätigerteilen zu erreichen, muss die charakteristische Energiesteuerung des jeweiligen Betätigerteils beim eingesetzten Senderteil bekannt sein. Dies hat eine Kostensteigerung des Endproduktes zur Folge und ist, ausser bei Sicherheit vor Diebstahl, kaum erwünscht. Solche Überwachungsvorrichtungen, bei denen der Sendeteil auf ein einziges Betätigerteil abgestimmt ist, lassen auch nicht zu, mit einem Sender mehrere gleich sichere Positionen von verschiedenen Empfängern zu erkennen.

Bei einer vorteilhaften Hardware-Lösung sendet der Schwingkreis des Betätigerteils in einer Frequenz, die weit entfernt ist von der Sendefrequenz des Senderteils. Im Senderteil können dann mit einfachsten Mitteln die Frequenzen gefiltert und so unterschieden werden. Der einfachste Dekoder, mit dem die Analyse der Leistungsmessung vorgenommen werden kann, besteht aus einem Widerstand gefolgt von Analogund/ oder Digitalfiltern und/ oder einem Differenzierer.

Die Steuerung einer Fehler/ Nichtfehler- Funktion kann örtlich vom Senderteil getrennt sein. Wenn es die Platzverhältnisse erlauben, können jedoch auch die Teile für die ganze Steuerung und die Überwachungsfunktion im Senderteil eingebaut sein.

Vorteilhaft werden jedoch wenigstens wesentliche Bestandteile des Senders, insbesondere ein Oszillator, eine Strommessung und eine Signalauswertung, direkt im Sendeteil untergebracht. Der Senderteil weist vorteilhaft einen Oszillator, mindestens ein schnelles Schaltelement, ein Phasenschieberglied, eine Spule und einen Anschluss an eine DC-Quelle auf.

Es dient der Sicherheit des Überwachungsgeräts, dass alle Schaltungsteile in der Messkette seriell liegen. Es können daher einzelne oder mehrere gleichzeitig fehlerhaft funktionierende Schaltungsteile einfach erkannt werden.

Um einen maximalen Messabstand zu erreichen, muss die Frequenz sowie der Spulendurchmesser möglichst gross gewählt werden. Für eine Miniaturisierung soll jedoch der Spulendurchmesser möglichst klein sein. Je höher die Frequenz gewählt wird, desto kleiner ist der Spulendurchmesser wählbar. Zweckmässige Frequenzen liegen über 1 MHz, eine besonders bevorzugte Frequenz liegt im Bereich 3 bis 10 MHz (abhängig von den Spulendaten). Frequenzen über 1 MHz oder entsprechend kurze Einschaltzeiten erlauben es, Luftspulen zu verwenden.

Um einen einfachen, leistungsfähigen Sender zu erhalten, ist der Oszillator vorteilhaft freischwingend aufgebaut und an zwei gegensinnig gewickelte Wicklungen einer Spule angeschlossen. Dies erlaubt mit der für einen Oszillator notwendigen Phasendrehung eine Feldverstärkung im Spulenzentrum und damit eine Erhöhung der Reichweite zu erreichen. Damit die gegensinnig gewickelten Wicklungen der Spule möglichst gleich stark wirken, wird eine bifilar gewickelte Spule zwei neben oder hinter einander angeordneten Wicklungen vorgezogen. Diese zwei Wicklungen bilden vorteilhaft zusammen mit zwei den Wicklungen zugeordneten MOSFET-Elementen einen Oszillator.

Im Empfangsteil wird die sendeseitig abgestrahlte Energie von der Spule aufgenommen, gleichgerichtet und in einem Kondensator oder in einer Batterie gespeichert. Der Energiespeicher speist eine Schaltung, welche es ermöglicht, den aktuellen Energieverbrauch zu steuern. Da diese Energieänderung sich auch in einer Änderung des Leistungsverbrauches im Sendeteil bemerkbar macht und dort dieser Leistungsverbrauch möglichst eindeutig erfasst werden soll, muss die Änderung vorteilhaft möglichst gross sein. Da jedoch ein hoher Leistungsverbrauch einen kleinen möglichen Messabstand zur Folge hat, wird die gespeicherte Energie im Betätigerteil vorteilhaft nicht einfach in Wärme umgewandelt. Dadurch, dass die gespeicherte Energie oder ein Teil davon zurück zum Empfänger gesendet wird, kann die Reichweite, innerhalb welcher die durch das Betätigerteil verursachten Leistungsverbrauchsschwankungen eindeutig erkennbar sind, erhöht werden. Durch Zurücksenden eines Teils der empfangenen Energie werden grössere Änderung in der Energiebilanz im Sendeteil ermöglicht. Dazu ist in der Schaltung des Betätigerteils lediglich eine weitere Diode, ein Schaltelement und eine Schalteransteuerung erforderlich.

Im Sendeteil müssen aus der aktuellen Leistungsmessung die normalen Verluste abgezogen und die Ergebnisse der Leistungsmessung für zusätzliche Informationen weiterverarbeitet werden. Dies kann mittels eines angepassten Differenzierers, in Hard und/ oder Software bewerkstelligt werden.

Eine Überwachungsvorrichtung, welche unabhängig von der Überwachungsart, mit welcher die Vorrichtung arbeitet, eine kleine Bauweise und eine gute Reichweite besitzt, weist folgende Merkmale auf: einen elektrischen Anschluss an eine Energieversorgung, eine DC-Versorgungsquelle, eine von der DC-Versorgungsquelle gespeiste AC-Quelle, eine mit der AC-Quelle verbundene erste Spule und eine mit einem Verbraucher verbundene zweite Spule. Die erste Spule ist Teil eines ersten Schwingkreises und in einem Senderteil angeordnet. Die zweite Spule ist in einem relativ zum Senderteil beweglichen Betätigerteil angeordnet. Die erste Spule weist zwei gegensinnig gewickelte Wicklungen auf. Diese Wicklungen bilden vorteilhaft zusammen mit zwei den Wicklungen zugeordneten MOSFET-Elementen einen Oszillator. Die gegensinnig gewickelten Wicklungen sind vorzugsweise die Wicklungen einer bifilar gewickelten Spule. Diese Spule ist vorzugsweise eine Luftspule. Ihre Betriebs-Frequenz liegt am besten im MHz-Bereich.

Anhand der Figuren wird die Erfindung im Detail erläutert. Es zeigt

Figur 1: eine einfaches Diagramm mit den Grundsätzlichen Bestandteilen einer erfindungsgemässen Überwachungsvorrichtung,

Figur 2: eine zweckmässige Schaltung eines Senderteils,

Figur 3: eine einfache Schaltung eines Betätigerteils,

Figur 4: eine verbesserte Schaltung eines Betätigerteils.

Figuren 5 bis 7 zeigen die unterschiedlichen Stromkreise für Laden der Energiespeicher (Fig. 5), Senden (Fig. 6) und Entladen (Fig. 7).

Figur 8 zeigt ein Schaltschema eines Betätigerteils mit integrierter Pulserzeugung und Codierung des Sendesignals.

Figur 9 zeigt ein Schaltschema eines Senderteils gemäss Figur 2, jedoch mit einer spannungsgesteuerten Stromquelle.

Figur 10 zeigt ein Schaltschema eines Betätigerteils mit einem Encoder und ohne Pulserzeugung.

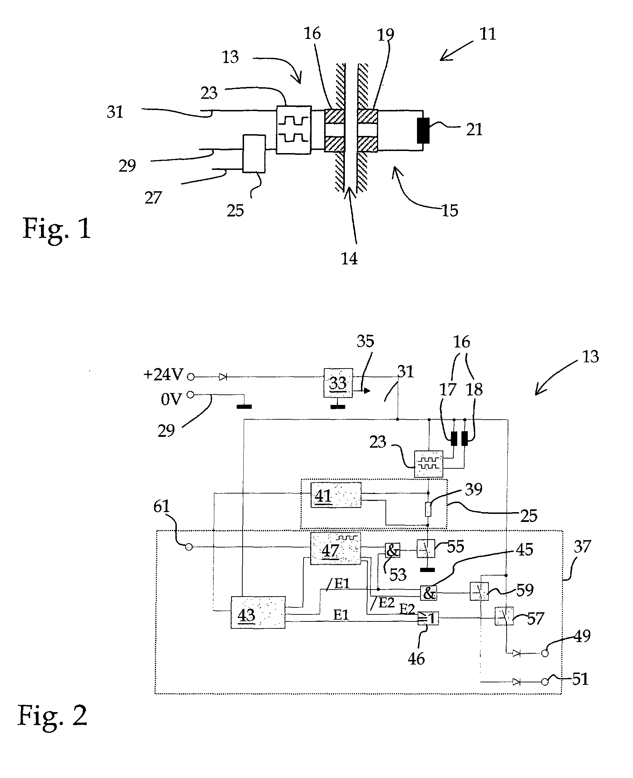

Die in Figur 1 diagrammatisch dargestellte Überwachungsvorrichtung 11 besitzt ein Senderteil 13 und ein Betätigerteil 15, welche durch einen Luftspalt 14 voneinander getrennt sind. Ein Versorgungsteil mit einer DC-Versorgungsquelle und ein Auswertteil mit einer Auswertelektronik sind vorhanden aber nicht dargestellt. Der Luftspalt 14 ist der Abstand zwischen einer ersten Spule 16 des Senderteils 13 und einer zweiten Spule 19 des Betätigerteils 15. Das Betätigerteil besteht in der dargestellten einfachsten Ausführungsform aus der zweiten Spule 19, an welche eine ohmsche Last 21 angeschlossen ist. Das Senderteil 13 besitzt einen an die Spule angeschlossenen Oszillator 23, eine Energiemesseinrichtung 25 und die Anschlüsse 29, 31 an eine DC-Versorgungsquelle, sowie einen Anschluss 27 der Energiemesseinrichtung 25 an eine nicht dargestellte Auswertelektronik.

Das Senderteil 13 muss für den Betrieb der Überwachungsvorrichtung mit den Anschlüssen 31 und 29 an eine DC-Versorgungsquelle und mit dem Anschluss 27 an eine Auswertelektronik angeschlossen sein. Der Oszillator 23 erregt eine Wechselspannung, die in der ersten Spule 16 ein Wechselmagnetfeld erzeugt. Das Wechselmagnetfeld induziert in der zweiten Spule 19 eine Wechselspannung. Die Wechselspannung wird mit der ohmschen Last 21 belastet. Dadurch wird elektrische Energie in Wärme umgewandelt und so dem System entzogen. Der Energieverbrauch im Senderteil 13 wird mit der Energiemesseinrichtung 25 erfasst. Die erfassten Werte können mittels einer Auswertelektronik ausgewertet werden. Die Auswertelektronik kann unterscheiden, ob der Energieverbrauch dem typischen Energieverbrauch entspricht, der dank der Nähe des Betätigerteils eintritt. Die Auswertelektronik kann ferner einen grösseren von einem kleineren Luftspalt unterschieden.

Das in Figur 2 dargestellte Schaltschema zeigt die Schaltung des Senderteils 13. Das Senderteil 13 ist mit einem Netzgerät (DC-Versorgungsquelle) 33 an eine 24V Energieversorgung angeschlossen. Das Netzgerät versorgt den dargestellten Schaltkreis über eine Leitung 31 und die Auswertelektronik 37 über eine Leitung 35 mit der notwendigen Energie. Der Schaltkreis des Senderteils 13 umfasst einen Oszillator 23 und eine diesem nachgeschaltete erste Spule 16. Der Oszillator 23 generiert im Zusammenhang mit den beiden gegensinnig gewickelten Wicklungen der erste Spule 16 zwei entgegengesetzte Wechselspannungen. Dadurch kann mit der selben Leistung des Oszillators 23 im Vergleich zu einer einfach gewickelten Spule eine praktisch doppelte Feldstärke erreicht werden.

Der Senderteil 13 gemäss Figur 2 weist ferner eine Energiemesseinrichtung 25 auf. Diese besteht aus einem Widerstand 39 in Reihe zwischen der DC-Versorgungsquelle und dem Oszillator 23 und einer Signalaufbereitung 41, welche die Spannung vor und nach dem Widerstand 39 abgreift. Aus der Spannungsdifferenz zwischen den beiden Messpunkten ist auf die Last zu schliessen, die der Schaltung Energie entzieht.

Die Auswertungselektronik 37 weist einen Signalauswertungsbaustein 43 auf, in welchem das aus der Signalaufbereitung 41 stammende Signal ausgewertet wird. Dieser Baustein 43 steuert das Aufstartverhalten über den Mikroprozessor 47, und erkennt Fehler. Er leitet Fehlermeldungen (Fehler: E1, und kein Fehler: /E1) an zwei unterschiedliche Verknüpfungslogik-Bausteine 45,46 weiter. Der Mikroprozessor 47 verarbeitet das vom Signalauswertungsbaustein 43 eingehende Signal. Der Mikroprozessor 47 entscheidet aufgrund seiner Signalanalyse und gibt ein Fehlersignal E2 aus. Der Mikroprozessor umfasst im Fall eines codierten Empfängers auch einen Decoder. Er steuert einen Aufstarttest und einen Betriebstest, wenn ein solcher vorgesehen ist. Er erzeugt ein Bereitsignal /E2. Der Mikroprozessor 47 taktet allenfalls die Ausgänge 49 und 51. Er schaltet über eine Freischaltlogik 53 und einen Stromschalter 55 den Oszillator 23 ein oder aus. Die vom Signalauswertungsbaustein 43 und vom Mikroprozessor 47 ausgehenden Fehlersignale E1 und E2 werden in einer Verknüpfungslogik 46 zu einem Fehlersignal der Auswertelektronik 37 zusammengefasst und über einen Schalter 57 zum Ausgang 49 geschaltet.

Die Signale "kein Fehler" /E1 und Betriebsbereit /E2 des Signalauswertungsbausteins 43, bzw. des Mikroprozessors 47 werden in der Verknüpfungslogik 45 zusammengefasst, welche ein "kein-Fehler-Signal" über einen Schalter 59 auf den Ausgang 51 geschaltet. Optional kann ein Test-Zugang 61 zum Mikroprozessor vorgesehen sein.

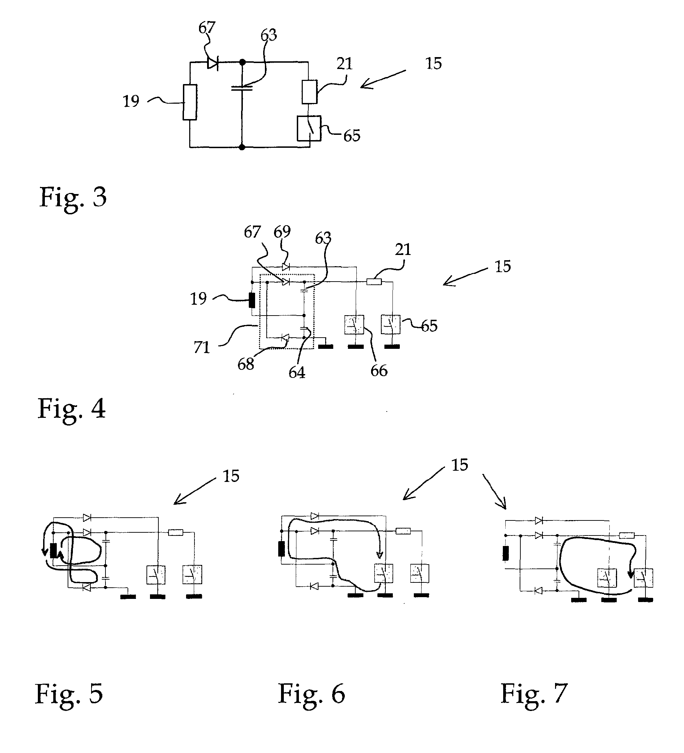

Die in Figur 3 dargestellte, einfache Schaltung des Betätigerteils 15 umfasst eine zweite Spule 19, einen Lastwiderstand 21, einen Kondensator 63, einen Schalter 65 und eine Diode 67. Spule 19, Diode 67 und Kondensator 63 bilden ein Netzteil mit Gleichrichter und Energiespeicherung. Die im Kondensator 63 gespeicherte Energie kann z.B. zyklisch über den Widerstand 21 entladen werden. Dadurch entsteht ein typisches Lastmuster.

Die in Figur 4 dargestellte Schaltung weist einen Sendekreislauf, zwei Ladekreisläufe und einen Entladekreislauf auf. Die Spule 19 bildet zusammen mit den Dioden 67, 68 und den Kondensatoren 63, 64 je einen in beide Richtungen der Wechselspannung gerichteten Ladekreislauf auf (Figur 5). Mit einer dritten Diode 69 , einem Schalter 66, dem einzelnen Kondensator 64 und der Spule 19 ist ein Sendekreislauf gebildet (Figur 6). Mit einem zweiten Schalter 65, dem Lastwiderstand 21 und den beiden Kodensatoren 63, 64 ist ein Enladungskreislauf gebildet (Figur 7). Die beiden Kondensatoren 63, 64 und die Dioden 67, 68 bilden zusammen einen Dioden-Gleichrichter 71.

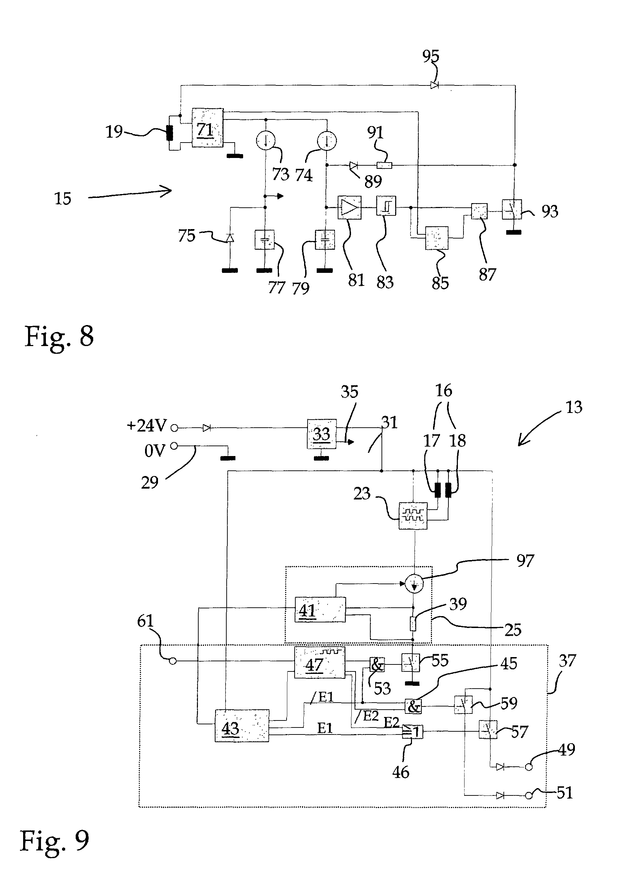

Ein bevorzugtes Schaltschema eines Betätigerteils 13 ist in der Figur 8 dargestellt. Dieses besitzt als Grundausrüstung die Spule 19, die an den Diodengleichrichter 71 angeschlossen ist. Der Diodengleichrichter 71 bildet dabei ein Netzteil, mit dem zwei Stromquellen 73, 74 aufgeladen werden. Die Stromquellen 73, 74 gewährleisten eine gleichmässige Verfügbarkeit der Energie. Die Stromquelle 73 dient der Versorgung der Mikroprozessoren oder Logikbausteine und ist mit einer Spannungsbegrenzungseinrichtung 75 und einem Energiespeicher 77 verbunden. Die zweite Stromquelle 74 arbeitet zusammen mit einem Kondensator 79 als Sägezahngenerator. Die zweite Stromquelle 74 und der Sägezahn-Kondensator bilden zusammen eine Zeitkonstante T1, die eine Ladezeit bestimmt. Der Sägezahn-Kondensator 79 bildet zusammen mit dem Entladewiderstand 21 eine zweite Zeitkonstante T2, die Entladezeit. Mit einem Spannungsteiler und Signalverstärker 81 und einem Schmitt Trigger oder Komperator 83 wird der Schalter 66 in einer Frequenz betätigt. Bei geschlossenem Schalter ist der Sendekreislauf geschlossen und die Spule 19 baut ein magnetisches Feld auf. Mit einem Encoder 85 kann die Spannung, der Strom oder die Leistung und damit dieses Feld moduliert werden. Die Codierung und die Schaltfrequenz können, wie gezeigt, kombiniert sein. Das Betätigerteil kann auch ohne Sägezahn- Kondensator lediglich einen Encoder mit den dazugehörigen Bausteinen zu einer Pulserzeugung aufweisen und daher die Kennung lediglich softwaremässig vornehmen. Es kann aber auch umgekehrt die Kennung lediglich hardwaremässig vorgenommen sein. Dann benötigt das Betätigerteil keinen Encoder 85.

Eine erfindungsgemässe Überwachungsvorrichtung 11 ist daher ein induktiver (Sicherheits-) Näherungsschalter. Dieser arbeitet wie folgt: Mit einer Luftspule 16 in einem Senderteil 13 wird in Messrichtung ein hochfrequentes elektromagnetisches Feld (etwa 3 bis 4 MHz) aufgebaut. Das elektromagnetische Wechselfeld wird von einem dem Senderteil 13 nahe genug angeordneten Betätigerteil 15 empfangen.

Im Betätigerteil 15 wird die vom Abstand abhängige Energie aus einer oder mehrerer Empfangsspule(n) 19 gleichgerichtet und in einem Kondensator 63, 64, 79 gespeichert. Ein Teil der gespeicherten Energie kann bei Bedarf zurück zum Sendeteil 13 gesendet oder einfach verbraucht werden. Die Spannung und somit der Energieinhalt des Kondensators ist abhängig vom aktuellen Kopplungsgrad der beiden Spulen 16,19 zueinander.

Wenn im Sendefeld ein ferromagnetisches Material eintaucht, verändert es den magnetischen Kreis. Ausserdem entstehen Wirbelstromverluste im Material, wodurch dem Schwingkreis des Senderteils 13 Energie entzogen wird. Durch diese Effekte wird die Stromaufnahme des Senderteils gegenüber einem Betrieb mit ungedämpftem Schwingkreis des Sendeteils verändert. Diese Veränderung ist aber deutlich zu unterscheiden von der Veränderung, die eintritt, wenn mittels dieses Felds ein magnetisch gekoppelter elektronischer Verbraucher (im Betätigerteil) versorgt wird.

Diese Veränderung der Senderleistung wird erkannt und mit einem Schwellwert verglichen. Abhängig vom Ergebnis des Vergleiches wird einer oder werden mehrere Ausgänge 49, 51 aktiv oder passiv geschaltet.

Die in Figur 9 dargestellten Schaltung des Senderteils 13 entspricht in allen Teilen der Schaltung gemäss Figur 2, besitzt jedoch zusätzlich eine spannungsgesteuerte Stromquelle 97. Diese Stromquelle 97 benutzt für den Stromregelkreis den Spannungsabfall am bereits vorhandenen Messwiderstand 39. Sie ist dadurch in der Lage, die temperaturabhängigen Widerstandsveränderungen (z.B. R-Kupfer der Sendespule) zu kompensieren. Die spannungsgesteuerte Stromquelle 97 ist dem Oszillator 23 vorgeschaltet.

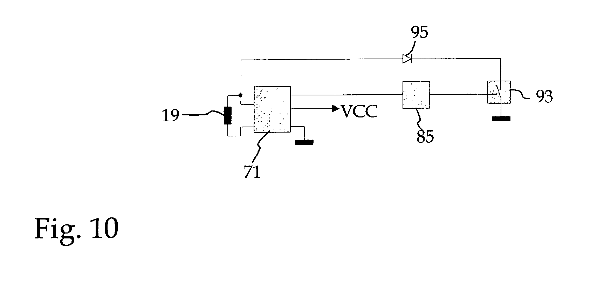

Die in Figur 10 dargestellte Schaltung des Betätigerteils 15 weist anstelle von Stromquellen und diskreter Bauelementen in der Schaltung gemäss Figur 8 lediglich das Netzteil 71, einen Encoder 85, einen Schalter 93 und den Verbraucherpfad/Energierücksendepfad über die Diode 95 auf.

Zusammenfassend gesagt, kann bei der erfindungsgemässen, induktiven Überwachungsvorrichtung 11 mit einer ersten Luftspule 16 in einem Senderteil 13 in Messrichtung ein hochfrequentes elektromagnetisches Feld aufgebaut werden (etwa 3 MHz), das eine Wechselspannung in einer zweiten Spule 19 eines Betätigerteils 15 induziert.

Im Betätigerteil 15 wird die vom Abstand abhängige Energie aus der empfangenden zweiten Spule 19 gleichgerichtet und z.B. in einem Kondensator gespeichert. Die gespeicherte Energie kann z.B. teilweise zurück zum Sendeteil 13 gesendet oder mit einer Last 21 auch einfach verbraucht werden (in Fig.3 bis Fig.7 ist die Last als ohmschen Verbraucher dargestellt).

Wenn mit dem elektromagnetischen Wechselfeld ein magnetisch gekoppelter elektronischer Verbraucher, z.B. ein Sender oder eine ohmsche Last, angeregt wird, so bewirkt dies eine Veränderung des Energieverbrauchs des Senderteil 13. Diese Veränderung der Senderleistung (dP/dt) wird erkannt und mit einem Schwellwert verglichen. Abhängig vom Ergebnis des Vergleiches wird wenigstens ein Ausgang der Überwachungsvorrichtung 11 aktiv oder passiv geschaltet.

Bezugsziffern:

| 11 | induktive Überwachungsvorrichtung, bestehend aus einem Senderteil 13 und einem Betätigerteil 15 |
| 13 | Senderteil mit einer ersten Spule 16 |
| 15 | Betätigerteil mit einer zweiten Spule 19, |
| 16 | erste Spule, insbesondere Luftspule, |
| 17,18 | zwei gegensinnig gewickelte und angeschlossene Wicklungen der Spule 16 zum Senden und Empfangen, insbesondere bifilar gewickelte Wicklungen, |
| 19 | zweite Spule, insbesondere Luftspule, des Betätigerteils 15 zum Empfangen und gegebenenfalls zum Senden. |
| 21 | Lastwiderstand |
| 23 | Freischwingender Oszillator in Kombination mit zwei Spulen. Er wird vom Netzteil versorgt. |
| 25 | Energiemesseinrichtung, vorzugsweise mit einem Strommesswiderstand 39, einem Signalfilter und einem differenzierenden Verstärker 41 |
| 27 | Ausgang der Strommesseinrichtung |
| 29,31 | Anschlüsse des Senderteils an eine Gleichstromquelle |
| 33 | Das Netzteil (DC-Versorgungsquelle) wird von einer externen Energieversorgung (im Beispiel gemäss Fig. 2 mit 24VDC) versorgt. Es speist den Oszillator und stellt die Speisung für die Logik zur Verfügung. |

| 35 | Ausgang des Netzteils zur Versorgung der Logikbausteine |
| 37 | Auswertelektronik |
| 39 | Strommesswiderstand (Für die Energierichtungsdetektion) |
| 41 | Signalfilter und Verstärker (Mehrstufiges AC-gekoppeltes Filter mit diversen kaskadierten Verstärkerstufen) |
| 43 | Analoge/ Digitale Signalauswertung 1 |
| | -Power- Up Logik (Aufstartverhalten) -Autonome Analog/ Digitalsignalauswertung für die Fehlererkennung und Weiterleitung (E1 und /E1) |
| 45 | Verknüpfunglogik 1 welche die beiden Signale "kein Fehler" /E1 und "bereit" /E2 der beiden Signalauswertungen (43,47) verbindet. |
| 46 | Verknüpfungslogik 2 welche aus einem der beiden erzeugten Signale (E1 und E2) ein Fehlersignal erzeugt. |
| 47 | Microprozessor Signalauswertung 2 |
| | -Oszillatorsteuerung (On/ Off) -Signalanalyse und Entscheid -Decoder für codierten Empfänger -Aufstarttest und Betriebstest -Fehlererzeugung (E2) -Bereiterzeugung (/E2) -Zusätzliches Takten der Ausgänge |
| 49 | Ausgang zu Anzeigegerät |
| 51 | Ausgang zu Anzeigegerät |
| 53 | Freischaltlogik für das Einschalten des Sendeoszillators. |
| 55 | Stromschalter Sendeoszillator welcher den Oszillator ein- und ausschaltet. |
| 57 | Stromschalter 1 welcher das erzeugte "Fehler- Signal" zum Anzeigegerät oder ausführenden Gerät weiterleitet. |
| 59 | Stromschalter 2 welcher das erzeugte "kein Fehler- Signal" zum Anzeigegerät oder ausführenden Gerät weiterleitet. |
| 61 | Testeingang |
| 63, 64 | Kondensatoren, gegebenenfalls des Gleichrichters 71 |
| 65, 66 | Schalter von Entladungskreislauf bzw. Sendekreislauf |
| 67, 68 | Dioden, gegebenenfalls des Gleichrichters 71 |
| 69 | Diode für Sendekreislauf |
| 71 | Netzteil und Energiespeicher 1 (Diodengleichrichter mit 2 Kondensatoren) |
| 73 | Stromquelle1 für die Versorgung der Logikbausteine. |
| 74 | Stromquelle2 für das Laden des Sägezahnkondensators. |
| 75 | Spannungsbegrenzungseinrichtung (Vcc) |
| 77 | Energiespeicher 2 |

79 Sägezahn-Ladekondensator (bildet zusammen mit der Stromquelle 74 die eigentliche Zeitkonstante T1)

81 Spannungsteiler und Signalverstärker

83 Schmitt Trigger oder Komparator

85 Encoder (zusätzlich Verschlüsselung oder auch autonomer Betrieb ohne Sägezahn möglich)

87 Verknüpfungslogik (Puls und Encoder) Art der Verknüpfung kann gewählt werden.

89 Lade-Sperrdiode und Entladespannungsbegrenzung.

91 Entladewiderstand (bildet in Fig. 8 zusammen mit dem Sägezahnkondensator die Zeitkonstante T2)

93 Stromschalter
Für das Entladen des Sägezahngenerators
Für die Teilenergierücksendung zum Sendeteil

95 Spannungsisolierdiode welche den Stromschalter isoliert (zur Verhinderung von negativen Spannungsüberschwingern).

97 spannungsgesteuerte Stromquelle

**Patentansprüche**

1. Überwachungsvorrichtung (11) mit einem elektrischen Anschluss an eine Energieversorgung, mit einer DC-Versorgungsquelle (33), mit einer von der DC-Versorgungsquelle (33) gespeisten AC-Quelle (23), mit einer mit der AC-Quelle (23) verbundenen ersten Spule (16), welche Teil eines Schwingkreises ist und in einem Senderteil (13) angeordnet ist, und mit einer mit einem Verbraucher (z.B. 21) verbundenen zweiten Spule (19), welche in einem relativ zum Senderteil (13) beweglichen Betätigerteil (15) angeordnet ist, **gekennzeichnet durch** eine Einrichtung (25) zur Messung des Energieverbrauchs des Senderteils (13), welche Einrichtung (25) der DC- Versorgungsquelle (33) vorgeschaltet, in der DC-Versorgungsquelle (33) integriert und/ oder zwischen der DC-Versorgungsquelle (33) und der ersten Spule (16) angeordnet ist.

2. Überwachungsvorrichtung nach Anspruch 1, **dadurch gekennzeichnet, dass** die Einrichtung (25) zur Messung des Energieverbrauchs des Senderteils (13) eine Energieverbrauchsänderung im Senderteil (13) misst.

3. Überwachungsvorrichtung nach Anspruch 1 oder 2, **dadurch gekennzeichnet, dass** die DC-Versorgungsquelle (33) konstant ist und die Einrichtung (25) zur Messung des Energieverbrauchs in der DC-Versorgungsquelle (33) integriert und/oder zwischen der DC-Versorgungsquelle (33) und der ersten Spule (16) angeordnet ist.

4. Überwachungsvorrichtung nach einem der Ansprüche 1 bis 3, **dadurch gekennzeichnet, dass** die Spulen (16,19) Luftspulen sind.

5. Überwachungsvorrichtung nach einem der Anspüche 1 bis 4, **dadurch gekennzeichnet, dass** die AC-Quelle ein an die Wicklung (17) oder die Wicklungen (17,18) der ersten Spule (16) angeschlossener Oszillator (23) ist, welcher Oszillator (23) vorteilhaft im Senderteil (13) angeordnet ist.

6. Überwachungsvorrichtung nach einem der Anspüche 1 bis 5, **dadurch gekennzeichnet, dass** ein Widerstand (39) in Reihe zwischen der ersten Spule (16) und der DC-Versorgungsquelle (33) angeordnet ist, und mit der Einrichtung (25) zur Messung des Energieverbrauchs der Spannungsabfall, insbesondere die Änderung des Spannungsabfalls am Widerstand (39) gemessen wird.

7. Überwachungsvorrichtung nach Anspruch 5 oder 6, **dadurch gekennzeichnet, dass** ein Hallelement (39) in Reihe zwischen der ersten Spule (16) und der DC-Versorgungsquelle (33) angeordnet ist, und mit der Einrichtung (25) zur Messung des Energieverbrauchs die Hallspannung, insbesondere die Hallspannungsänderung gemessen wird.

8. Überwachungsvorrichtung nach einem der Anspüche 1 bis 7, **dadurch gekennzeichnet, dass** der Widerstand (39) bzw. das Hallelement zwischen der DC-Versorgungsquelle (33) und der AC-Quelle (23) angeordnet ist.

9. Überwachungsvorrichtung nach einem der Anspüche 1 bis 8, **dadurch gekennzeichnet, dass** die erste Spule (16) zwei Wicklungen (17,18) aufweist, welche gegensinnig an zwei einander entgegengesetzten Ausgängen des Oszillators (23) angeschlossen sind.

10. Überwachungsvorrichtung nach Anspruch 9, **dadurch gekennzeichnet, dass** die zwei Wicklungen (17,18) der ersten Spule (16) zusammen mit zwei den Wicklungen (17,18) zugeordneten MOSFET-Elementen einen Oszillator bilden.

11. Überwachungsvorrichtung nach Anspruch 9 oder 10, **dadurch gekennzeichnet, dass** die erste Spule (16) bifilar gewickelt ist.

12. Überwachungsvorrichtung nach einem der Anspüche 1 bis 11, **dadurch gekennzeichnet, dass** der Verbraucher (z.B. 21, 91, 19) eine zeitlich veränderliche Last darstellt.

13. Überwachungsvorrichtung nach einem der Anspüche 1 bis 12, **dadurch gekennzeichnet, dass** die zweite Spule (19) an eine mit der in der zweiten Spule (16) induzierten Spannung aufladbare Versorgungsquelle (63, 64, 71) angeschlossen ist, und mit dieser einen als Sender wirkenden zweiten Schwingkreis zum Aufbauen eines Magnetfeldes in der zweiten Spule (19) bildet.

14. Überwachungsvorrichtung nach Anspruch 13, **dadurch gekennzeichnet, dass** die Frequenz des Wechselmagnetfeldes der ersten Spule (16) und die Frequenz des Magnetfeldes der zweiten Spule (19) unterschiedlich sind, vorzugsweise einen grossen Frequenzabstand aufweisen, besonders bevorzugt um eine bis mehrere Dekaden.

15. Überwachungsvorrichtung nach einem der Anspüche 1 bis 14, **dadurch gekennzeichnet, dass** die Frequenz der ersten Spule (16) grösser als 1 MHz ist, vorteilhaft mehrere MHz.

16. Überwachungsvorrichtung nach einem der Anspüche 1 bis 15, **dadurch gekennzeichnet, dass** zur Analyse der Leistungsmessung des Senders ein Widerstand gefolgt von einem oder mehreren Analog- und/oder Digitalfiltem und/oder eines Differenzierers vorhanden ist.

17. Verfahren zur Überwachung des Abstands zwischen einer ersten Spule (16) eines Senderteils (13) und einer zweiten Spule (191) eines Betätigerteils (15), bei welchem mit der ersten Spule (16) ein Wechsel-Magnetfeld aufgebaut wird und mit dem Wechsel-Magnetfeld in der an einen Verbraucher angeschlossenen zweiten Spule (19) eine Wechselspannung induziert wird, **dadurch gekennzeichnet, dass** der gegenseitige Abstand der Spulen (16,19) mittels einer Energiebilanz des Senderteils (13) während dem Aufbauen des Wechselmagnetfeldes überwacht wird.

18. Überwachungsvorrichtung (11) mit einem elektrischen Anschluss an eine Energieversorgung, mit einer DC-Versorgungsquelle (33), mit einer von der DC-Versorgungsquelle (33) gespeisten AC-Quelle (23), mit einer mit der AC-Quelle (23) verbundenen ersten Spule (16), welche Teil eines ersten Schwingkreises ist und in einem Senderteil (13) angeordnet ist, und mit einer mit einem Verbraucher (z.B. 21) verbundenen zweiten Spule (19), welche in einem relativ zum Senderteil (13) beweglichen Betätigerteil (15) angeordnet ist, **dadurch gekennzeichnet, dass** die erste Spule (16) zwei gegensinnig gewickelte Wicklungen (17,18) aufweist.

19. Überwachungsvorrichtung nach Anspruch 18, **dadurch gekennzeichnet, dass** die beiden gegensinnig gewickelten Wicklungen (17,18) der ersten Spule (16) zusammen mit zwei den Wicklungen (17,18) zugeordneten MOSFET-Elementen einen Oszillator bilden.

20. Überwachungsvorrichtung nach Anspruch 18 oder 19, **dadurch gekennzeichnet, dass** die erste Spule (16) eine bifilar gewickelte Luftspule ist.

Fig. 1

Fig. 2

EP 1 455 454 A2

Fig. 3

Fig. 4

Fig. 5    Fig. 6    Fig. 7

12

Fig. 8

Fig. 9

Fig. 10